# FASCICULE DE BREVET EUROPEEN

(11) **EP 3 220 729 B1**
(45) Date de publication et mention de la délivrance du brevet: **22.05.2019**
(21) Numéro de dépôt: 17155427.2
(22) Date de dépôt: 09.02.2017
(51) Int. Cl.: H05K 7/20, H01L 23/42, H01L 23/367, H01L 23/433

(54) **DISPOSITIF ELECTRONIQUE ET METHODE D ASSEMBLAGE D'UN TEL DISPOSITIF**
ELEKTRONISCHE VORRICHTUNG UND METHODE ZUM ZUSAMMENBAU DIESER VORRICHTUNG
ELECTRONIC DEVICE AND METHOD FOR ASSEMBLING SUCH A DEVICE

(30) Priorité: 15.03.2016 FR 1670105
(43) Date de publication de la demande: 20.09.2017
(73) Titulaire: Aptiv Technologies Limited, St. Michael (BB)
(72) Inventeur: STOERMER, Peter, 42859 REMSCHEID (DE); FRUEND, Marcel, 42859 Remscheid (DE)
(74) Mandataire: Robert, Vincent

(56) Documents cités:
- EP-A2- 2 802 199
- WO-A1-03/079436
- JP-A- 2006 156 465
- US-A1- 2003 184 969

## Description

### DOMAINE TECHNIQUE

La présente invention concerne un dispositif électronique pour véhicule automobile et plus particulièrement un dispositif de dissipation thermique pour carte à circuit imprimé.

### ARRIERE-PLAN TECHNOLOGIQUE DE L'INVENTION

Les dispositifs électroniques pour véhicule automobile comportent généralement des composants électroniques montés sur une carte à circuit imprimé. Certain composants électroniques sont des composants produisant de la chaleur. Il peut s'agir de microcontrôleurs dont la vitesse de traitement de donnée est telle que le microcontrôleur chauffe lors de ses opérations, ou encore par exemple, il peut s'agir de composants électroniques distribuant de forts courants électriques aux équipements du véhicule, ou encore simplement de pistes conductrices véhiculant de forts courants à travers la carte à circuit imprimé.

Afin de refroidir ces composants pour éviter leur défaillance, il est connu de dissiper leur chaleur en couplant directement thermiquement ces composants à un boîtier thermo conducteur du dispositif. Généralement, afin de garantir un couplage thermique permanent lors notamment du roulage du véhicule dans lequel le dispositif est embarqué et soumis à des vibrations, le couvercle du boîtier servant de radiateur de refroidissement des composants est vissé à la carte à circuit imprimé de sorte à maintenir une zone protubérante du couvercle vers l'intérieur du boîtier en contact permanent avec le composant générant de la chaleur.

Il est apparu que lors de l'assemblage de tels dispositifs et également lors de sollicitations en vibrations de tels dispositifs lors du roulage du véhicule embarquant de tels dispositifs, la rigidité de l'assemblage vissé entraine des défaillances des composants refroidis, notamment des cassures de soudures des composants ou encore un endommagement du composant entrainant une défaillance de celui-ci. Il est également apparu qu'une telle structure s'avère peu évolutive puisque généralement, lors d'une mise à jour matériel de la disposition des composants électroniques montés sur la carte à circuit imprimé, une nouvelle conception du couvercle du boîtier est à prévoir afin d'ajuster le positionnement des protubérances du couvercle venant en contact direct avec les composants produisant de la chaleur pour assurer leur refroidissement. Le document US2003/184969A1 concerne une unité de commande électronique pouvant être placée dans un compartiment moteur d'un véhicule. Le document JP2006156465A concerne un dispositif de dissipation thermique pour un composant électronique d'un appareil électronique.

Il est donc important de proposer une solution nouvelle résolvant ces problèmes.

### RESUME DE L'INVENTION

Un dispositif électronique pour véhicule automobile comporte un boîtier thermiquement conducteur contenant une carte à circuit imprimé et un élément produisant de la chaleur monté sur la carte à circuit imprimé. Le boîtier comporte un fond de boîtier sur lequel est monté la carte à circuit imprimé et comportant un couvercle opposé au fond de boîtier. Une première structure métallique de dissipation thermique est montée sur l'élément produisant de la chaleur, et une deuxième structure métallique de dissipation thermique, qui est réalisée venue de matière avec le couvercle du boîtier et protubérante dans le boîtier, est couplée avec la première structure métallique de dissipation thermique, de manière à faciliter la dissipation de l'énergie thermique depuis l'élément produisant de la chaleur vers l'extérieur du boîtier.

La première structure métallique de dissipation thermique et la deuxième structure métallique de dissipation thermique peuvent comporter chacune une pluralité d'ailettes interdigitées les unes avec les autres. Les ailettes de dissipation thermique interdigitées peuvent comprendre des flancs obliques couplés thermiquement entre eux. La première structure métallique de dissipation thermique peut comprendre moins d'ailettes que la deuxième structure métallique de dissipation thermique. Le dispositif électronique peut comprendre des espaces entres les ailettes interdigitées, les dits espaces comprenant un matériau thermo conducteur e manière à coupler thermiquement les ailettes interdigitées. La carte à circuit imprimé peut comprendre plusieurs premières structures métalliques à ailettes de dissipation thermique dont chaque hauteur de chaque première structure métallique à ailettes est adaptée à la distance séparant l'élément produisant de la chaleur avec la face intérieure du couvercle du boîtier de manière à faciliter la dissipation de l'énergie thermique depuis l'élément produisant de la chaleur vers l'extérieur du boîtier. Le couvercle du boîtier peut comprendre plusieurs deuxièmes structures métalliques à ailettes de dissipation thermique dont chaque hauteur de chaque deuxième structure métallique à ailettes est adaptée à la distance séparant l'élément produisant de la chaleur avec la face intérieure du couvercle du boîtier de manière à faciliter la dissipation de l'énergie thermique depuis l'élément produisant de la chaleur vers l'extérieur du boîtier. La première structure métallique de dissipation thermique peut-être fixée sur l'élément produisant de la chaleur associé au moyen d'une couche adhésive thermo conductrice. Le couvercle du boîtier peut comprendre des ailettes de dissipation thermique sur sa surface extérieure.

Une méthode d'assemblage du dispositif électronique pour véhicule automobile décrit ci-dessus comprend les étapes de :
fournir une carte à circuit imprimé comprenant des élément produisant de la chaleur;
   fixer la carte à circuit imprimé sur un fond de boîtier;
fixer un matériau thermo conducteur sur les éléments produisant de la chaleur;
fixer des premières structures métalliques à ailettes de dissipation thermique sur les matériaux thermo conducteur placés sur les éléments produisant de la chaleur;
disposer un autre matériau thermo conducteur sur les ailettes des premières structures métalliques de dissipation thermique fixées sur les éléments produisant de la chaleur;
fournir un couvercle de boîtier thermiquement conducteur comprenant des structures à ailettes protubérantes vers l'intérieur du boîtier;
fermer le boîtier en plaçant le couvercle du boîtier sur le fond de boîtier de sorte à interdigiter et à coupler thermiquement les structures à ailettes du couvercle du boîtier avec les structures à ailettes des éléments produisant de la chaleur; le couplage thermique étant réalisé par compression du matériau thermoconducteur préalablement disposé sur les ailettes des premières structures de dissipation thermique entre les flancs des ailettes interdigitées.

### BREVE DESCRIPTION DES DESSINS

D'autres caractéristiques, buts et avantages de l'invention apparaîtront à la lecture de la description détaillée qui va suivre, et en regard des dessins annexés, donnés à titre d'exemple non limitatif et sur lesquels:
- La figure 1 est une vue schématique éclatée en perspective et en coupe transversale d'un dispositif électronique pour véhicule automobile selon un premier mode de réalisation de l'invention.
- La figure 2 est une vue schématique en coupe transversale du dispositif électronique assemblé de la figure 1.
- La figure 3 est une vue schématique en coupe transversale du dispositif électronique de la figure 1 pour lequel l'agencement des composants électroniques a été modifié.
- La figure 4 est une vue schématique de la carte à circuit imprimé du dispositif électronique de la figure 1.
- La figure 5 est une vue schématique de la carte à circuit imprimé du dispositif électronique de la figure 1 équipée de structures de dissipation thermique.

### DESCRIPTION DES MODES DE REALISATION PREFERES

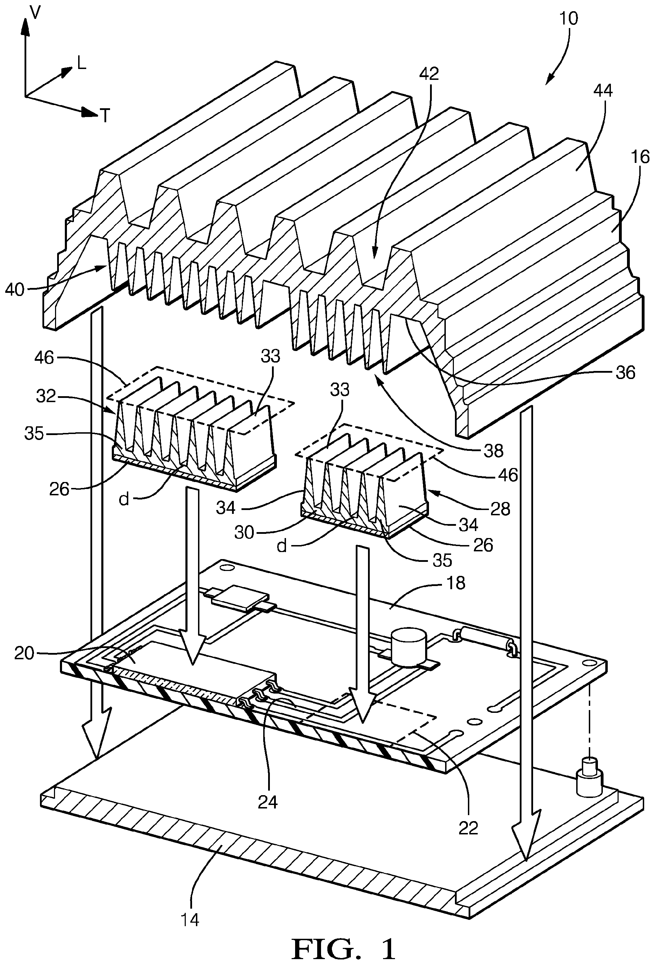

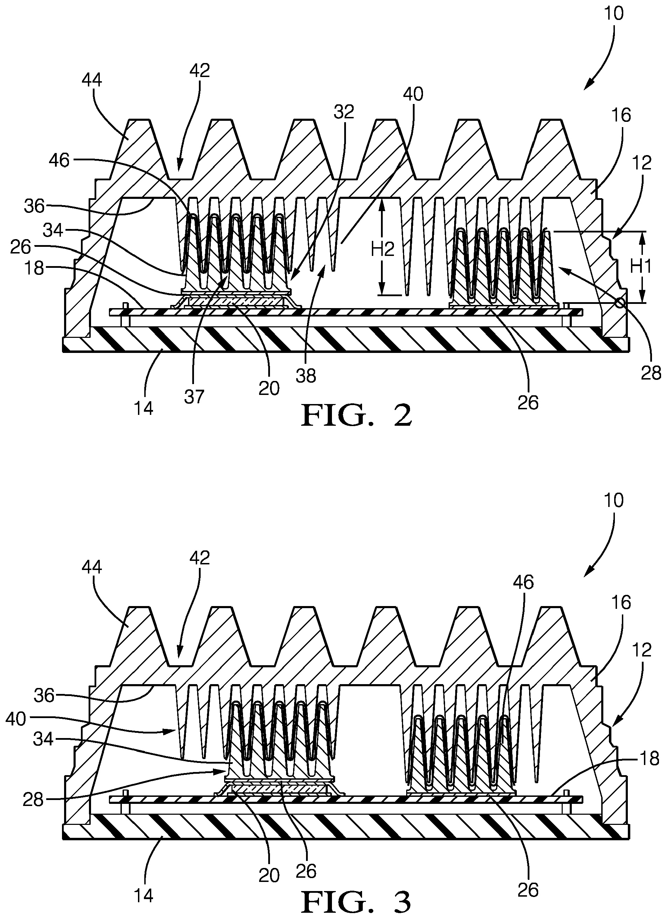

Selon la figure 1 et la figure 2, un dispositif électronique 10 pour véhicule comprend un boîtier 12 formé par un fond de boîtier 14, un couvercle 16 et une carte à circuit imprimé 18 monté en fond de boîtier 14 à l'intérieur du boîtier 12.

La carte à circuit imprimé 18 est équipée de composants électroniques 20 reliés électriquement entre eux par des pistes conductrices 24 telles que des pistes de cuivre. Un composant électronique 20 et une zone de la carte à circuit imprimé traversée par des pistes conductrices 24 sont recouverts d'un premier matériaux thermo conducteur adhésif 26 telle que de la pâte thermique. Le premier matériau thermo conducteur 26 se présente de préférence sous forme de ruban adhésif type double face. Des premières structures métalliques de dissipation thermique 28 sont fixées sur les premiers matériaux thermo conducteurs 26 grâce aux propriétés adhésives du matériau thermo conducteur 26. Le composant électronique 20 et la zone de la carte à circuit imprimé 22 traversée par les pistes conductrices 24 sont des éléments produisant de la chaleur et refroidis par les premières structures métalliques de dissipation thermique 28. Bien que pour la suite de l'exposé de l'invention, le dispositif électronique 10 comprend deux éléments produisant de la chaleur, il est bien évident que l'invention couvre tous les modes de réalisation de dispositif électronique 10 comportant au moins un élément produisant de la chaleur 20.

Pour la suite de la description et de façon non limitative, selon la figure 1, un repère orthogonal défini un axe vertical V, un axe transversal T et un axe longitudinal L.

Les premières structures métalliques de dissipation thermique 28 comportent une plaque de base 30 de dimension globalement similaire à la surface des éléments produisant de la chaleur sur laquelle s'étendent des ailettes de dissipation thermique 32 suivant l'axe vertical V vers la face intérieure 36 du couvercle du boîtier 16 opposée au fond de boîtier 14. Les ailettes 32 ont un profil en section suivant l'axe transversal T de forme triangulaire. Le sommet 33 de chaque ailette 32 s'étend suivant l'axe longitudinal L tout le long de la plaque de base 30. Les bases 35 des ailettes 32 sont espacées transversalement de façon régulière d'une distance d du même ordre de grandeur que la largeur de leur base 35. Les ailettes 32 ont donc la forme d'un prisme à base triangulaire. Chaque ailette 32 comporte deux flancs obliques 34 s'étendant longitudinalement tout le long de la plaque de base. Le nombre d'ailettes 32 est défini de sorte à couvrir l'ensemble de la plaque de base 30. La plaque de base 30 et les ailettes 32 forment une seule pièce.

Le couvercle du boîtier 16 est formé par un métal thermoconducteur tel que l'aluminium ou le magnésium. Le couvercle du boîtier 16 comporte sur sa face intérieure 36 opposée au fond de boîtier 14 des deuxièmes structures métalliques de dissipation thermique 38 formant des protubérances vers l'intérieur du boîtier 12. Les deuxièmes structures métalliques de dissipation thermique 38 sont venues de matière avec le couvercle du boîtier 16. Les deuxièmes structures métalliques de dissipation thermique 38 comportent également des ailettes de dissipation thermique 40 espacées entre-elles de façon régulière de manière à pouvoir être interdigitées avec les ailettes de dissipation thermique des premières structures métalliques 32. Les deuxièmes structures métalliques de dissipation thermique 38 sont de forme géométrique similaire aux premières structures métalliques de dissipation thermique 28; les ailettes 40 des deuxièmes structures métalliques de dissipation thermique s'étendant suivant l'axe vertical V vers le fond du boîtier 14 de sorte à pouvoir être interdigitées avec les ailettes 32 de la première structure métallique de dissipation thermique 28.

Dans le contexte de l'invention, le terme 'interdigité' doit s'interpréter comme une insertion des ailettes 32 des premières structures métalliques de dissipation 28 entre les ailettes 40 des deuxièmes structures métalliques de dissipation 38. Le couvercle 16 comprend également sur sa face extérieure 42 opposée à la carte à circuit imprimé 18 d'autres ailettes de dissipation thermique 44 de façon à optimiser la dissipation thermique. De préférence, ces autres ailettes de dissipation thermique 44 situées sur la face extérieure 42 du couvercle 16 et les ailettes de dissipation thermique 40 des deuxièmes structures métalliques 38 s'étendent toutes suivant la même direction afin de faciliter la réalisation par injection du couvercle 16. Il est à noter que toutefois, les autres ailettes 44 placées sur la face extérieure du couvercle 42 peuvent ne pas être essentielles au dispositif 10, cette optimisation dépendant notamment de la puissance thermique à dissiper.

Selon la figure 1, avant assemblage, des morceaux d'un second matériau thermoconducteur 46 de forme globalement rectangulaire telle que des morceaux de pâte thermoductrice sont disposés de façon plane au sommet 33 des ailettes 32 de dissipation thermique des premières structures métalliques 28. Les morceaux du second matériau thermoconducteur 46 couvrent l'ensemble des ailettes 32 des premières structures métalliques de dissipation thermique 28 et présente une dimension selon l'axe transversal T supérieure à la dimension selon l'axe transversal T des premières structures métalliques de dissipation thermique 28. Selon la figure 2, les dimensions du second matériau thermoconducteur 46 placé avant assemblage au sommet 33 des ailettes 32 des premières structures métalliques 28, permettent au second matériau thermoconducteur 46 de s'agencer en compression entre tous les flancs 34 des ailettes interdigitées 32, 40 des premières 28 et des deuxièmes structures métalliques 38 de dissipation après assemblage du couvercle du boîtier 16 avec le fond de boîtier 14.

Selon la figure 2, lorsque le couvercle du boîtier 16 ferme le boîtier 12 du dispositif électronique 10, les ailettes 32, 40 des premières et des deuxièmes structures métalliques de dissipations thermiques 28, 38 sont interdigitées entre elles de façon à être couplées thermiquement entre elles. Le second matériau thermoconducteur 46 situé sur les flancs 34 des ailettes interdigitées 32, 40 est un matériau souple de manière à être compressé entre les ailettes interdigitées 32, 40 et donc en contact avec les ailettes interdigitées 32, 40. En d'autres termes, les espaces 37 entre les ailettes interdigitées 32, 40 comportent l'autre matériau thermo conducteur 46 disposé sur les flancs 34 des ailettes 32, 40 assurant ainsi un couplage thermique efficace entre les ailettes interdigitées 32, 40. Le second matériau thermoconducteur 46 réalise un joint thermique entre les ailettes interdigitées 32, 40. De préférence, les espaces 37 entre les ailettes interdigitées 32, 40 ont une dimension selon l'axe transversal T inférieure au millimètre, l'épaisseur du second matériau thermoconducteur 46 étant supérieure à cette dimension de sorte à être compressé entre les ailettes intedigitées 32, 40. Selon cet assemblage, une grande partie de l'énergie thermique des éléments produisant de la chaleur 20, 22 est dissipée vers l'extérieur du boîtier 12. Selon cet assemblage, de par les caractéristiques du second matériau thermoconducteur 46 assurant le couplage entre les ailettes interdigitées 32, 40, les deuxièmes structures métalliques de dissipation thermique 38 venue de matière avec le couvercle 16 ne nécessitent pas de fixations spécifiques avec la carte à circuit imprimé 18. Cet assemblage permet également de s'affranchir de vis de fixation entre les structures métalliques de dissipation thermique 28, 38 et la carte à circuit imprimé 18, réduisant ainsi le risque d'endommagements de la carte à circuit imprimé 18 ou des éléments produisant de la chaleur 20, 22.

De façon alternative, le second matériau thermoconducteur 46 réalisant les joints thermiques entre les ailettes interdigitées 32, 40 peut être remplacée par de la graisse thermiquement conductrice de type graisse silicone chargée d'oxyde métallique préalablement disposée sur les flancs 34 des ailettes 32 des premières structures métalliques. De façon également alternative, le second matériau thermoconducteur 46 réalisant les joints thermiques entre les ailettes interdigitées 32, 40 peut être une structure préformée de forme complémentaire à la forme des ailettes 32 des premières structures métalliques de dissipation 28 de sorte à être placée entre ces ailettes 32 avant l'assemblage du couvercle 16.

La hauteur du composant électronique 20 est généralement de l'ordre d'un ou quelques millimètres tandis que l'épaisseur des pistes conductrices 24 est équivalente à l'épaisseur de cuivre utilisée pour la conception de ces pistes de cuivre forts courants, c'est à dire une épaisseur de l'ordre de quelques dizaines voire centaines de micromètres. Les deux premières structures métalliques de dissipation thermiques 28 placées sur les deux éléments produisant de la chaleur 20, 22 ont une hauteur d'ailettes H1 similaire entre elles alors que les deuxièmes structures de dissipation 38 protubérantes vers l'intérieur du boîtier 12 ont chacune une hauteur d'ailettes H2 différentes. Les différences de hauteur H2 des ailettes 40 des deuxièmes structures métalliques de dissipation 38 permettent de compenser la différence de distance entre les éléments produisant de la chaleur 20, 22 et la surface intérieure du couvercle 36 de sorte à garder l'espace 37 entre les ailettes interdigitées 32, 40 globalement similaire pour toutes les structures métalliques de dissipation thermiques utilisées pour le dispositif électronique, permettant ainsi d'utiliser une même épaisseur du second matériau thermoconducteur 46 placée entre les ailettes interdigitées 32, 40.

De façon alternative, les premières structures métalliques de dissipation 28 peuvent avoir une hauteur H1 d'ailette 32 différente entre elles afin également de compenser la différence de hauteur des éléments produisant de la chaleur 20, 22. Si besoin, il est également possible d'avoir une hauteur H1, H2 d'ailettes 32, 40 différente pour chaque structure métallique de dissipation thermique 28, 38.

Selon la figure 2 et la figure 3, le nombre d'ailettes 40 des deuxièmes structures métalliques de dissipation thermique 38 est supérieure au nombre d'ailettes 32 des premières structures métalliques de dissipation thermique 28. Un avantage technique du surnombre d'ailettes 40 des deuxièmes structures métalliques de dissipation thermique 38 est la flexibilité offerte de pouvoir faire évoluer le placement du composant électronique 20 produisant de la chaleur et de de la zone de la carte à circuit imprimé 22 traversées pas pistes conductrices 24 de forts courants sans avoir à développer un nouveau couvercle de boîtier 16. De préférence, ce déplacement est au voisinage de la position initiale des éléments produisant de la chaleur. Grâce à ce surnombre, dans le cas tel que représenté à la figure 3 en comparaison avec la figure 2, malgré le déplacement du composant électronique 20 produisant de la chaleur et de de la zone de la carte à circuit imprimé 22 traversées pas pistes conductrices 24 de forts courants, les ailettes 32 des premières structures métalliques de dissipation thermique 28 restent toutes interdigitées avec les ailettes 40 des deuxièmes structures métalliques de dissipation thermique 38. Ce surnombre d'ailettes 40 permet également une flexibilité sur la dimension des éléments produisant de la chaleur.

Selon d'autres modes de réalisation, les ailettes 32, 40 des structures métalliques de dissipation thermique 28, 38 peuvent avoir des formes différentes des formes représentées sur les figures 1, 2 et 3. Les ailettes 32, 40 des structures métalliques de dissipation 28, 38 doivent avoir des formes géométriquement complémentaires afin de pouvoir être interdigitées tout en assurant entre elles un couplage thermique par le biais de joints thermiques réalisés par le matériau thermoconducteur 46. Les ailettes 32, 40 de chaque structure métallique de dissipation thermique 28, 38 peuvent également être espacées entre elles de façon non régulière si nécessaire. Les ailettes 40 des deuxièmes structures métalliques de dissipation 38 peuvent également s'étendre selon l'axe longitudinal de façon plus grande que les ailettes 32 des premières structures métalliques de dissipation thermique 28 de sorte à également permettre une évolution selon l'axe longitudinal du positionnement des éléments produisant de la chaleur ou de la taille des éléments produisant de la chaleur.

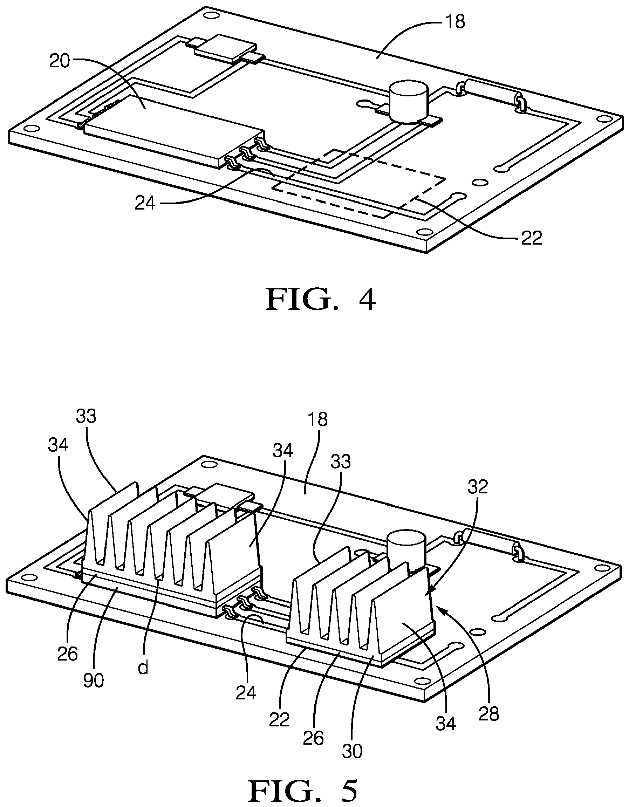

Selon les figures 1, 4 et 5 un assemblage du dispositif électronique 10 pour véhicule automobile est schématisé. Selon la figure 4, la carte à circuit imprimé 18 comprend les composants électroniques 20 et les pistes conductrices 22 les reliant entre eux. Les éléments produisant de la chaleur lorsque le dispositif est en fonctionnement ont été déterminés. Les éléments produisant de la chaleur identifiés sont la zone de circuit imprimé 22 traversée par des pistes conductrices 24 de courants forts 22 telle que modélisée par la zone encadrée en pointillées selon la figure 3 et le composant électronique 20 de type circuit intégré. Selon la figure 5, le premier matériau thermoconducteur 26 a été placé sur la surface des éléments produisant de la chaleur 20, 22. Selon la figure 5, les premières structures métalliques de dissipation thermiques 28 ont été placées sur les premiers matériaux thermoconducteurs 26 placés eux même sur les éléments produisant de la chaleur. Le maintien des premières structures métalliques de dissipation thermique 28 est assuré par les propriétés adhésives du premier matériau thermoconducteur 26. Selon la figure 1, la carte à circuit imprimé 18 est placée sur le fond de boîtier 14 et est maintenue par des pions de maintien. Selon la figure 1, des morceaux du second matériau thermoconducteur 46 sont placés de façon plane au sommet 33 des ailettes 32 de dissipation thermique des premières structures métalliques 28 de manière à pouvoir être compressés entre les ailettes 32 des premières structures métalliques 28 et les ailettes 40 des deuxièmes structures métalliques 38 de dissipation thermique lorsque le couvercle du boîtier 16 vient fermer le dispositif électronique 10.

De façon alternative, une structure préformée du second matériau thermoconducteur 46 de forme complémentaire à la forme des ailettes 32 des premières structures métalliques de dissipation 28 peut être placée entre les ailettes 32 des premières structures métalliques de dissipation 28 avant l'assemblage du couvercle 16.

De préférence, le dispositif 10 est fermé par le couvercle 16 de façon étanche.

## Revendications

1. Dispositif électronique (10) pour véhicule automobile comportant un boîtier (12) thermiquement conducteur contenant une carte à circuit imprimé 5 (18) et un élément produisant de la chaleur (20) monté sur la carte à circuit imprimé (18);
un matériau thermo-conducteur (26) fixé sur l' élément produisant de la chaleur; le boîtier (12) comportant un fond de boîtier (14) sur lequel est monté la carte à circuit imprimé (18) et comportant un couvercle (16) opposé au fond de boîtier (14), une première structure métallique de dissipation thermique (28) étant montée sur l'élément produisant de la chaleur (20), une deuxième structure métallique de dissipation thermique (38), qui est réalisée venue de matière avec le couvercle du boîtier (16) et protubérante dans le boîtier (12), étant couplée avec la première structure métallique de dissipation thermique (28), de manière à faciliter la dissipation de l'énergie thermique depuis l'élément produisant de la chaleur (20) vers l'extérieur du boîtier (12) ;
la première structure métallique de dissipation thermique (28) et la deuxième structure métallique de dissipation thermique (38) comportant chacune une pluralité d'ailettes (32, 40) interdigitées les unes avec les autres ; **caractérisé en ce que** le dispositif comprend des espaces (37) entres les ailettes (32, 40) interdigitées, les dits espaces (37) comprenant des morceaux de pâte thermoductrice globalement rectangulaire (46), préalablement disposés sur le sommet des ailettes (32) des premières structures de dissipation thermique (28), de manière à coupler thermiquement les ailettes (32, 40) interdigitées.

2. Dispositif électronique 10 suivant la revendication 1 **caractérisé en ce que** les ailettes (32, 40) de dissipation thermique interdigitées comprennent des flancs obliques (34) couplés thermiquement entre eux.

3. Dispositif électronique (10) suivant l'une quelconque des revendications précédentes **caractérisé en ce que** la première structure métallique de dissipation thermique (28) comprend moins d'ailettes (32) que la deuxième structure métallique de dissipation thermique (38).

4. Dispositif électronique (10) suivant l'une quelconque des revendications précédentes **caractérisé en ce que** la carte à circuit imprimé (18) comprend plusieurs premières structures métalliques à ailettes (32) de dissipation thermique (28) dont chaque hauteur (H1) de chaque première structure métallique à ailettes (28) est adaptée à la distance séparant l'élément produisant de la chaleur (20) avec la face intérieure (36) du couvercle du boîtier (16) de manière à faciliter la dissipation de l'énergie thermique depuis l'élément produisant de la chaleur (20) vers l'extérieur du boîtier (12).

5. Dispositif électronique (10) suivant l'une quelconque des revendications précédentes **caractérisé en ce que** le couvercle du boîtier (16) comprend plusieurs deuxièmes structures métalliques à ailettes (40) de dissipation thermique (38) dont chaque hauteur (H2) de chaque deuxième structure métallique à ailettes (38) est adaptée à la distance séparant l'élément produisant de la chaleur (20) avec la face intérieure (36) du couvercle du boîtier (16) de manière à faciliter la dissipation de l'énergie thermique depuis l'élément produisant de la chaleur (20) vers l'extérieur du boîtier (12).

6. Dispositif électronique (10) suivant l'une quelconque des revendications précédentes **caractérisé en ce que** la première structure métallique de dissipation thermique (28) est fixée sur l'élément produisant de la chaleur (20) associé au moyen d'une couche adhésive thermo conductrice (26).

7. Dispositif électronique (10) suivant l'une quelconque des revendications précédentes **caractérisé en ce que** le couvercle du boîtier (16) comprend des ailettes de dissipation thermique (44) sur sa surface extérieure (42).

8. Méthode d'assemblage d'un dispositif électronique (10) pour véhicule automobile suivant l'une quelconque des revendications précédentes comprenant les étapes de :
fournir une carte à circuit imprimé (18) comprenant des élément produisant de la chaleur (20, 22) ;
fixer la carte à circuit imprimé (18) sur un fond de boîtier (14) ;
fixer un matériau thermo conducteur (26) sur les éléments produisant de la chaleur (20, 22) ;
fixer des premières structures métalliques à ailettes (32) de dissipation thermique (28) sur les matériaux thermo conducteur (26) placés sur les éléments produisant de la chaleur (20, 22);
disposer des morceaux de pâte thermoductrice globalement rectangulaire (46) (46) sur le sommet des ailettes (32) des premières structures métalliques de dissipation thermique (28) fixées sur les éléments produisant de la chaleur (20, 22);
fournir un couvercle (16) de boîtier thermiquement conducteur comprenant des structures à ailettes (38) protubérantes vers l'intérieur du boîtier (12);
fermer le boîtier (12) en plaçant le couvercle (16) du boîtier (12) sur le fond de boîtier (14) de sorte à interdigiter et à coupler thermiquement les structures à ailettes (38) du couvercle (16) du boîtier avec les structures à ailettes (28) des éléments produisant de la chaleur (20, 22); le couplage thermique étant réalisé par compression des morceaux de pâte thermoductrice globalement rectangulaire (46) préalablement disposés sur le sommet des ailettes (32) des premières structures de dissipation thermique (28) entre les flancs (34) des ailettes (32, 40) interdigitées.

## Patentansprüche

1. Elektronische Vorrichtung (10) für Kraftfahrzeuge, enthaltend:
ein wärmeleitendes Gehäuse (12), das eine gedruckte Leiterplatte (18) und ein wärmeerzeugendes Element (20) enthält, das an der gedruckten Leiterplatte (18) angebracht ist;
ein wärmeleitendes Material (26), das an das wärmeerzeugende Element befestigt ist,
wobei das Gehäuse (12) einen Gehäuseboden (14) enthält, an dem die gedruckte Leiterplatte (18) angebracht ist, sowie eine Abdeckung (16), die dem Gehäuseboden (14) entgegengesetzt ist, wobei eine erste Wärmeableitungsstruktur (28) aus Metall an dem wärmeerzeugenden Element (20) angebracht ist und eine zweite Wärmeableitungsstruktur (38) aus Metall, die stoffschlüssig mit der Abdeckung des Gehäuses (16) ausgebildet ist und in das Gehäuse (12) hineinragt, mit der ersten Wärmeableitungsstruktur (28) aus Metall gekoppelt ist, so dass die Ableitung von Wärmeenergie von dem wärmeerzeugenden Element (20) nach außerhalb des Gehäuses (12) erleichtert wird;
wobei die erste Wärmeableitungsstruktur (28) aus Metall und die zweite Wärmeableitungsstruktur (38) aus Metall jeweils eine Mehrzahl von Rippen (32, 40) aufweisen, die ineinandergreifen;
**dadurch gekennzeichnet, dass**
die Vorrichtung Freiräume (37) zwischen den ineinandergreifenden Rippen (32, 40) aufweist, wobei die Freiräume (37) Stücke einer rechteckförmigen Wärmeleitpaste (46) enthalten, die zuvor auf den Scheitel der Rippen (32) der ersten Wärmeableitungsstrukturen (28) aufgebracht wurden, so dass die ineinandergreifenden Rippen (32, 40) thermisch gekoppelt werden.

2. Elektronische Vorrichtung (10) nach Anspruch 1, **dadurch gekennzeichnet, dass** die ineinandergreifenden Wärmeableitungsrippen (32, 40) schräge Flanken (34) enthalten, die thermisch miteinander gekoppelt sind.

3. Elektronische Vorrichtung (10) nach einem der vorangehenden Ansprüche, **dadurch gekennzeichnet, dass** die erste Wärmeableitungsstruktur (28) aus Metall weniger Rippen (32) als die zweite Wärmeableitungsstruktur (38) aus Metall aufweist.

4. Elektronische Vorrichtung (10) nach einem der vorangehenden Ansprüche, **dadurch gekennzeichnet, dass** die gedruckte Leiterplatte (18) mehrere erste Wärmeableitungsstrukturen (28) aus Metall mit Rippen (32) enthält, wovon jede Höhe (H1) einer jeden Rippenstruktur (28) aus Metall an den Abstand angepasst ist, der das wärmeerzeugende Element (20) von der Innenseite (36) der Gehäuseabdeckung (16) trennt, so dass die Ableitung von Wärmeenergie von dem wärmeerzeugenden Element (20) nach außerhalb des Gehäuses (12) erleichtert wird.

5. Elektronische Vorrichtung (10) nach einem der vorangehenden Ansprüche, **dadurch gekennzeichnet, dass** die Gehäuseabdeckung (16) mehrere zweite Wärmeableitungsstrukturen (38) aus Metall mit Rippen (40) enthält, wovon jede Höhe (H2) einer jeden zweiten Rippenstruktur (38) aus Metall an den Abstand angepasst ist, der das wärmeerzeugende Element (20) von der Innenseite (36) der Gehäuseabdeckung (16) trennt, so dass die Ableitung von Wärmeenergie von dem wärmeerzeugenden Element (20) nach außerhalb des Gehäuses (12) erleichtert wird.

6. Elektronische Vorrichtung (10) nach einem der vorangehenden Ansprüche, **dadurch gekennzeichnet, dass** die erste Wärmeableitungsstruktur (28) aus Metall an das wärmeerzeugende Element (20) befestigt ist, das mittels einer wärmeleitenden Haftschicht (26) zugeordnet ist.

7. Elektronische Vorrichtung (10) nach einem der vorangehenden Ansprüche, **dadurch gekennzeichnet, dass** die Gehäuseabdeckung (16) Wärmeableitungsrippen (44) an ihrer Außenfläche (42) enthält.

8. Verfahren zum Montieren einer elektronischen Vorrichtung (10) für Kraftfahrzeuge nach einem der vorangehenden Ansprüche, umfassend die Schritte:
Bereitstellen einer gedruckten Leiterplatte (18), die wärmeerzeugende Elemente (20, 22) enthält;
Befestigen der gedruckten Leiterplatte (18) an einen Gehäuseboden (14);
Befestigen eines wärmeleitenden Materials (26) an die wärmeerzeugenden Elemente (20, 22);
Befestigen von ersten Wärmeableitungsstrukturen (28) aus Metall mit Rippen (32) an die wärmeleitenden Materialien (26), die an den wärmeerzeugenden Elementen (20, 22) angeordnet sind;
Anordnen von Stücken aus rechteckförmiger Wärmeleitpaste (46) (46) am Scheitel der Rippen (32) der ersten Wärmeableitungsstruktur (28) aus Metall, die an die wärmeerzeugenden Elemente (20, 22) befestigt sind;
Bereitstellen einer wärmeleitenden Gehäuseabdeckung (16) mit in das Innere des Gehäuses (12) hineinragenden Rippenstrukturen (38);
Schließen des Gehäuses (12), indem die Abdeckung (16) des Gehäuses (12) am Gehäuseboden (14) angeordnet wird, so dass die Rippenstrukturen (38) der Gehäuseabdeckung (16) mit den Rippenstrukturen (28) der wärmeerzeugenden Elemente (20, 22) ineinandergreifen und thermisch gekoppelt werden; wobei die thermische Kopplung durch Zusammendrücken der Stücke aus rechteckförmiger Wärmeleitpaste (46) erfolgt, die zuvor am Scheitel der Rippen (32) der ersten Wärmeableitungsstrukturen (28) zwischen den Flanken (34) der ineinandergreifenden Rippen (32, 40) angeordnet wurden.

## Claims

1. Electronic device (10) for motor vehicles comprising a heat-conducting housing (12) containing a printed circuit board (18) and an element producing heat (20) mounted on the printed circuit board (18);
a heat-conductive material (26) fixed onto the element producing heat;
the housing (12) comprising a housing base (14) on which the printed circuit board is mounted (18) and comprising a cover (16) opposite to the housing base (14), a first heat-dissipating metal structure (28) being mounted on the element producing heat (20), a second heat-dissipating metal structure (38), which is formed as part of the cover of the housing (16) and protruding into the housing (12), being coupled with the first heat-dissipating metal structure (28) in such a manner as to facilitate the dissipation of the thermal energy from the element producing heat (20) towards the outside of the housing (12);
the first heat-dissipating metal structure (28) and the second heat-dissipating metal structure (38) each comprising a plurality of fins (32, 40) interdigitated with one another; **characterized in that** the device comprises gaps (37) between the interdigitated fins (32, 40), the said gaps (37) comprising pieces of globally rectangular heat-conductive paste (46), previously disposed on the tips of the fins (32) of the first heat-dissipating structures (28), in such a manner as to thermally couple the interdigitated fins (32, 40).

2. Electronic device 10 according to Claim 1, **characterized in that** the interdigitated heat-dissipating fins (32, 40) comprise oblique sidewalls (34) thermally coupled to one another.

3. Electronic device (10) according to either one of the preceding claims, **characterized in that** the first heat-dissipating metal structure (28) comprises fewer fins (32) than the second heat-dissipating metal structure (38) .

4. Electronic device (10) according to any one of the preceding claims, **characterized in that** the printed circuit board (18) comprises several first heat-dissipating metal structures (28) with fins (32) for which each height (H1) of each first metal structure with fins (28) is adapted to the distance separating the element producing heat (20) from the internal face (36) of the cover of the housing (16) in such a manner as to facilitate the dissipation of the thermal energy from the element producing heat (20) towards the outside of the housing (12).

5. Electronic device (10) according to any one of the preceding claims, **characterized in that** the cover of the housing (16) comprises several second heat-dissipating metal structures (38) with fins (40) for which each height (H2) of each second metal structure with fins (38) is adapted to the distance separating the element producing heat (20) from the internal face (36) of the cover of the housing (16) in such a manner as to facilitate the dissipation of the thermal energy from the element producing heat (20) towards the outside of the housing (12) .

6. Electronic device (10) according to any one of the preceding claims, **characterized in that** the first heat-dissipating metal structure (28) is fixed onto the associated element producing heat (20) by means of a heat-conductive adhesive layer (26).

7. Electronic device (10) according to any one of the preceding claims, **characterized in that** the cover of the housing (16) comprises heat-dissipating fins (44) on its external surface (42).

8. Method of assembling an electronic device (10) for motor vehicles according to any one of the preceding claims comprising the steps for:
supplying a printed circuit board (18) comprising elements producing heat (20, 22);
fixing the printed circuit board (18) onto a housing base (14) ;
fixing a heat-conductive material (26) onto the elements producing heat (20, 22);
fixing first heat-dissipating metal structures (28) with fins (32) onto the heat-conductive materials (26) placed on the elements producing heat (20, 22);
disposing pieces of globally rectangular heat-conductive paste (46) (46) on the tips of the fins (32) of the first heat-dissipating metal structures (28) fixed onto the elements producing heat (20, 22);
supplying a cover (16) for a heat-conductive housing comprising structures with fins (38) protruding towards the inside of the housing (12);
closing the housing (12) by placing the cover (16) of the housing (12) on the housing base (14) in such a manner as to interdigitate and to thermally couple the structures with fins (38) of the cover (16) of the housing with the structures with fins (28) of the elements producing heat (20, 22), the thermal coupling being implemented by compression of the pieces of globally rectangular heat-conductive paste (46) previously disposed on the tips of the fins (32) of the first heat-dissipating structures (28) between the sidewalls (34) of the interdigitated fins (32, 40).
